# EUROPEAN PATENT APPLICATION

(11) **EP 4 756 458 A1**
(43) Date of publication of application: **10.06.2026**
(21) Application number: 25749220.7
(22) Date of filing: 22.01.2025
(51) Int. Cl.: G01R 31/392, G01R 31/3835, G01R 31/396, G01R 19/30, G01R 19/12, G01R 19/165, G01R 31/36, G08B 21/18, B60L 58/16

(54) **APPARATUS AND METHOD FOR DIAGNOSING BATTERY**

(30) Priority: 31.01.2024 KR 20240014930
(71) Applicant: LG Energy Solution, Ltd., Seoul 07335 (KR)
(72) Inventor: KIM, Ju-Ri, Daejeon 34122 (KR); BAE, Yoon-Jung, Daejeon 34122 (KR); KIM, Se-Ram, Daejeon 34122 (KR); JEONG, Hee-Seok, Daejeon 34122 (KR)
(74) Representative: Goddar, Heinz J.
(86) International application number: PCT/KR2025/099133
(87) International publication number: WO 2025/165181

(57) **Abstract**

The apparatus for diagnosing a battery according to an embodiment of the present disclosure includes a profile obtaining unit configured to obtain a differential profile representing a corresponding relationship between a differential capacity and a voltage of a battery; and a control unit configured to determine a target peak from the differential profile, calculate a voltage change rate based on a SOH of the battery and a target voltage of the target peak, and compare the calculated voltage change rate with a preset reference change rate to diagnose a state of the battery.

## Description

### TECHNICAL FIELD

This application is based on and claims priority from Korean Patent Application No. 10-2024-0014930, filed on January 31, 2024, with the Korean Intellectual Property Office, the disclosure of which is incorporated herein in its entirety by reference.

The present disclosure relates to an apparatus and method for diagnosing a battery, and more particularly, to an apparatus and method for diagnosing a battery, which diagnoses a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being conducted on these batteries in terms of high capacity and high density, improving lifespan and safety is also important. In order to improve battery safety, technology that accurately diagnoses the current state of the battery is required.

### DISCLOSURE

### Technical Problem

The present disclosure is designed to solve the problems of the related art, and therefore the present disclosure is directed to providing an apparatus and method for diagnosing a battery, which diagnoses a state of a battery in a non-destructive manner.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

An apparatus for diagnosing a battery according to one aspect of the present disclosure may comprise a profile obtaining unit configured to obtain a differential profile representing a corresponding relationship between a differential capacity and a voltage of a battery; and a control unit configured to determine a target peak from the differential profile, calculate a voltage change rate based on a SOH of the battery and a target voltage of the target peak, and compare the calculated voltage change rate with a preset reference change rate to diagnose a state of the battery.

The control unit may be configured to determine a peak with a largest differential capacity among a plurality of peaks included in the differential profile as the target peak.

The control unit may be configured to calculate the voltage change rate by calculating a ratio of a voltage change amount of the target voltage to a SOH change amount of the battery.

The control unit may be configured to calculate the ratio of the voltage change amount to the SOH change amount in a SOH section less than or equal to a preset reference SOH.

The control unit may be configured to generate an SOH profile representing a corresponding relationship between the SOH of the battery and the target voltage of the target peak and calculate the voltage change rate from the reference SOH section of the SOH profile.

The control unit may be configured to diagnose the state of the battery as a normal degradation state when the voltage change rate exceeds the reference change rate.

The control unit may be configured to diagnose the state of the battery as an abnormal degradation state when the voltage change rate is less than the reference change rate.

The control unit may be configured to change at least one of a maximum allowable temperature, an upper limit SOC, a lower limit SOC and an upper limit C-rate set for the battery when the state of the battery is the normal degradation state.

The control unit may be configured to output an alarm when the state of the battery is the abnormal degradation state.

A battery pack according to another aspect of the present disclosure may comprise the apparatus for diagnosing a battery according to one aspect of the present disclosure.

A vehicle according to still another aspect of the present disclosure may comprise the apparatus for diagnosing a battery according to one aspect of the present disclosure.

A method for diagnosing a battery according to still another aspect of the present disclosure may comprise a profile obtaining step of obtaining a differential profile representing a corresponding relationship between a differential capacity and a voltage of a battery; a target peak determining step of determining a target peak from the differential profile; a voltage change rate calculating step of calculating a voltage change rate based on a SOH of the battery and a target voltage of the target peak; and a diagnosing step of comparing the calculated voltage change rate with a preset reference change rate to diagnose a state of the battery.

### Advantageous Effects

According to one aspect of the present disclosure, the apparatus for diagnosing a battery has the advantage of being able to diagnose the state of a battery in a non-destructive manner by considering both the target voltage of the target peak and the SOH of the battery.

In addition, according to one aspect of the present disclosure, the apparatus for diagnosing a battery has the advantage of being able to track and diagnose the state of the battery throughout the life cycle of the battery, because it diagnoses the state of the battery according to the voltage change rate of the target peak for each SOH.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a drawing schematically showing a differential profile according to an embodiment of the present disclosure.
FIG. 3 is a drawing schematically showing a SOH profile according to an embodiment of the present disclosure.
FIG. 4 is a drawing schematically showing a battery pack according to another embodiment of the present disclosure.
FIG. 5 is a drawing schematically showing a vehicle according to still another embodiment of the present disclosure.
FIG. 6 is a diagram schematically showing a method for diagnosing a battery according to still another embodiment of the present disclosure.

### BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

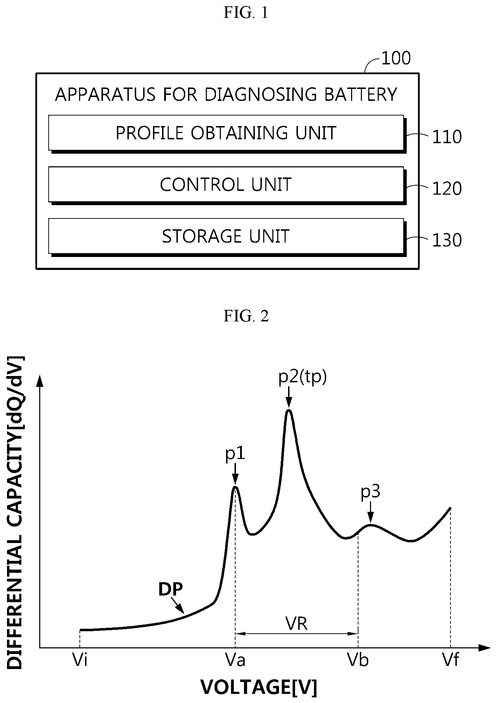

FIG. 1 is a diagram schematically illustrating an apparatus 100 for diagnosing a battery according to an embodiment of the present disclosure.

Referring to FIG. 1, the apparatus 100 for diagnosing a battery may include a profile obtaining unit 110 and a control unit 120.

Here, the battery refers to an independent cell that has a negative terminal and a positive terminal and is physically separable. As an example, a lithium-ion battery or a lithium polymer battery may be considered as a battery. In addition, the type of batteries may be a cylindrical type, a prismatic type or a pouch type. Additionally, the battery may mean a battery bank, a battery module or a battery pack in which a plurality of cells are connected in series and/or parallel. Below, for convenience of explanation, the battery is explained as meaning one independent cell.

The profile obtaining unit 110 may be configured to obtain a differential profile DP representing a corresponding relationship between the differential capacity and voltage of the battery.

For example, the battery profile is a profile representing the corresponding relationship between voltage V and capacity Q when the SOC of the battery is charged from a preset charge start SOC, or 0%, to a preset charge end SOC, or 100%. As another example, the battery profile may represent the corresponding relationship between voltage V and capacity Q when the state of charge of the battery is discharged from the preset discharge start SOC, or 100%, to the preset discharge end SOC, or 0%.

Then, by differentiating the battery profile with respect to voltage, a differential profile DP representing the corresponding relationship between differential capacity (dQ/dV) and voltage (V) may be generated.

For example, there is no special limitation on the C-rate in charging or discharging for generating the battery profile. However, preferably, the battery should be charged or discharged at a low rate in order to obtain a more accurate battery profile and differential profile DP. For example, the battery profile may be generated in the process of charging or discharging the battery at 0.05 C.

For example, the profile obtaining unit 110 may directly receive the differential profile DP of the battery from the outside. That is, the profile obtaining unit 110 may obtain the differential profile DP by being connected to the outside by wire and/or wirelessly and receiving the differential profile DP.

As another example, the profile obtaining unit 110 may directly receive the battery profile of the battery from the outside. Then, the profile obtaining unit 110 may differentiate the battery profile with respect to the voltage to generate a differential profile DP. That is, the profile obtaining unit 110 may obtain the differential profile DP by receiving the battery profile through a wired and/or wireless connection to the outside, and directly generating the differential profile DP from the battery profile.

As another example, the profile obtaining unit 110 may receive battery information about the voltage and capacity of the battery. Then, the profile obtaining unit 110 may generate a battery profile based on the received battery information, and generate a differential profile DP based on the generated battery profile. That is, the profile obtaining unit 110 may obtain a differential profile DP by directly generating the differential profile DP based on the battery information.

FIG. 2 is a drawing schematically illustrating a differential profile DP according to an embodiment of the present disclosure. For example, the differential profile DP may be expressed as an X-Y graph where the X-axis is set to voltage and the Y-axis is set to differential capacity.

The profile obtaining unit 110 may be connected to communicate with the control unit 120. For example, the profile obtaining unit 110 may be connected to the control unit 120 by wire and/or wirelessly. The profile obtaining unit may transmit the obtained differential profile DP to the control unit 120.

The control unit 120 may be configured to determine a target peak in the differential profile DP.

Specifically, the differential profile DP may include a plurality of peaks p1, p2, p3. Here, the peak is a local maximum of the differential profile DP, which is a point where the instantaneous change rate of the differential capacity with respect to the voltage is 0. The control unit 120 may determine one of the plurality of peaks p1, p2, p3 included in the differential profile DP as a target peak based on the voltage or the differential capacity.

Preferably, the control unit 120 may be configured to determine a peak having the largest differential capacity among the plurality of peaks p1, p2, p3 included in the differential profile DP as the target peak.

For example, in the embodiment of FIG. 2, the differential profile DP may include a first peak p1, a second peak p2, and a third peak p3. Since the differential capacity of the second peak p2 is the largest among the first to third peaks p1, p2, p3, the control unit 120 may determine the second peak p2 as the target peak.

The control unit 120 may be configured to calculate a voltage change rate based on the state of health (SOH) of the battery and the target voltage of the target peak.

Specifically, the control unit 120 may calculate the change rate of the target voltage of the target peak as the SOH of the battery decreases. To this end, data on the target voltage for each SOH of the battery may be stored in advance. That is, data on the target voltage for each SOH measured in the past for the battery may be stored in advance.

In one embodiment, the control unit 120 may calculate the capacity of the battery from the battery profile and/or the differential profile DP. Then, the control unit 120 may calculate the SOH of the battery by calculating a ratio between the calculated capacity and the initial capacity preset for the battery. For example, the control unit 120 may calculate the SOH of the battery by calculating the formula of "calculated capacity ÷ initial capacity × 100."

In another embodiment, the profile obtaining unit 110 and/or the control unit 120 may receive the SOH of the battery from the outside. For example, when the profile obtaining unit 110 receives battery-related information (at least one of the battery information, the battery profile, and the differential profile DP) from the outside, the profile obtaining unit 110 may receive the SOH of the battery together, and the control unit 120 may receive the SOH of the battery from the profile obtaining unit 110. As another example, the control unit 120 may directly receive information about the SOH of the battery from an external device.

The control unit 120 may be configured to calculate a voltage change rate by calculating a ratio of a voltage change amount of the target voltage to a SOH change amount of the battery.

For example, control unit 120 may calculate the voltage change rate by calculating the formula "voltage change amount ÷ SOH change amount."

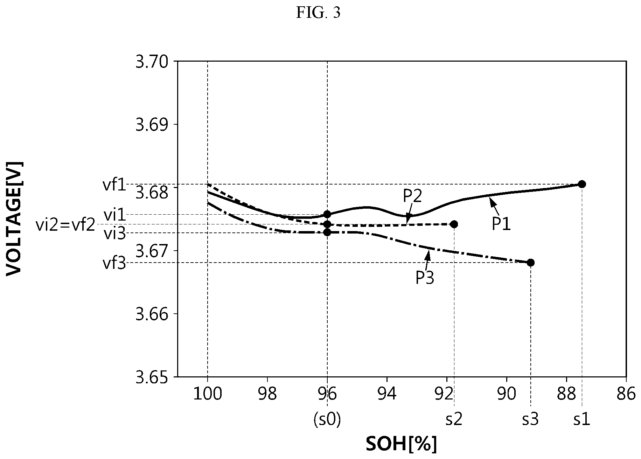

FIG. 3 is a drawing schematically showing a SOH profile according to an embodiment of the present disclosure. For example, the SOH profile may be expressed as an X-Y graph with the X-axis set to SOH and the Y-axis set to voltage. Specifically, FIG. 3 includes a first SOH profile P1 for the first battery, a second SOH profile P2 for the second battery, and a third SOH profile P3 for the third battery.

For example, in the embodiment of FIG. 3, it is assumed that the voltage change rates of the first to third SOH profiles p1, p2, p3 are calculated based on the reference SOH. The SOH change amount of the first SOH profile P1 is "S1 - S0 (%)", and the voltage change amount of the first SOH profile P1 is "vf1 - vi1 [V]". The SOH change amount of the second SOH profile P2 is "S2 - S0 (%)", and the voltage change amount of the second SOH profile P2 is "vf2 - vi2 [V]". The SOH change amount of the third SOH profile P3 is "S3 - S0 (%)", and the voltage change amount of the third SOH profile P3 is "vf3 - vi3 [V]". Here, the voltage change amount of the first SOH profile P1 may be a positive number, the voltage change amount of the second SOH profile P2 may be 0 [V], and the voltage change amount of the third SOH profile P3 may be a negative number.

In the embodiment of FIG. 3, the voltage of the first SOH profile P1 decreases around SOH 94%, but the voltage increases in the SOH sections of s0 to s1. Therefore, the voltage change amount of the first SOH profile P1 may be calculated as a positive number. That is, even if the voltage increases or decreases in some SOH sections, the voltage change amount for the SOH profile may be calculated based on the change in voltage in the entire SOH section considered.

The control unit 120 may be configured to diagnose the state of the battery by comparing the calculated voltage change rate with a preset reference change rate.

Specifically, the reference change rate may be a reference value preset for distinguishing the state of the battery. Therefore, the control unit 120 may diagnose the state of the battery by directly comparing the calculated voltage change rate with the reference change rate. Preferably, the control unit 120 may compare the size of the calculated voltage change rate with the reference change rate.

For example, the control unit 120 may be configured to diagnose the state of the battery as a normal degradation state if the voltage change rate exceeds the reference change rate. Here, the normal degradation state means that the degradation of the battery belongs to a preset normal degradation category. For example, the normal degradation state means a state in which the active material included in the battery is degraded, but an abnormal degradation pattern is not confirmed.

As another example, the control unit 120 may be configured to diagnose the state of the battery as an abnormal degradation state if the voltage change rate is less than the reference change rate. Here, the abnormal degradation state means that the degradation of the battery does not fall within a preset normal degradation category. For example, the abnormal degradation state means a state in which lithium plating (Li-plating) where lithium metal is precipitated from the negative electrode of the battery occurs.

The apparatus 100 for diagnosing a battery has the advantage of being able to diagnose the state of a battery in a non-destructive manner by considering both the target voltage of the target peak and the SOH of the battery.

In addition, since the apparatus 100 for diagnosing a battery diagnoses the state of the battery according to the voltage change rate of the target peak for each SOH, it has the advantage of being able to track and diagnose the state of the battery throughout the entire cycle of the battery.

Meanwhile, the profile obtaining unit 110 and the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the profile obtaining unit 110 and the control unit 120 may be implemented as a set of program modules. At this time, the program module may be stored in the memory and executed by the profile obtaining unit 110 and the control unit 120. The memory may be inside or outside the profile obtaining unit 110 and the control unit 120 and may be connected to the profile obtaining unit 110 and the control unit 120 by various well-known means.

In addition, the apparatus 100 for diagnosing a battery may further include a storage unit 130. The storage unit 130 may store data necessary for operation and function of each component of the apparatus 100 for diagnosing a battery, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the profile obtaining unit 110 and the control unit 120 are defined.

For example, the storage unit 130 may store the differential profile DP obtained by the profile obtaining unit 110. In addition, the storage unit 130 may store mapping information between the SOH for the battery and the voltage change rate. That is, the storage unit 130 may store various data used to diagnose the state of the battery.

Preferably, the control unit 120 may determine the peak that is located in the target voltage region VR of the differential profile DP and has the largest differential capacity as the target peak.

Specifically, the control unit 120 may determine the peak that is located in the target voltage region VR from the voltage of the first peak p1 to a predetermined voltage and has the largest differential capacity as the target peak tp.

For example, in the embodiment of FIG. 2, the voltage of the first peak p1 is Va [V]. The target voltage region VR may be preset as a voltage region from Va [V] to voltage Vb [V]. Here, the voltage Vb [V] may be a voltage that is a predetermined ratio larger than the voltage (Va) of the first peak p1. For example, Vb [V] is a voltage that is 10% larger than Va [V], and if Va [V] is 3.5 [V], Vb [V] may be 3.85 [V].

Since the apparatus 100 for diagnosing a battery determines the target peak by limiting the target voltage region VR, the time for determining the target peak may be shortened. In addition, if the battery is significantly degraded, the differential capacity of the second peak p2 may be smaller than that of the first peak p1 or the third peak p3. Even in this case, the apparatus 100 for diagnosing a battery has an advantage in that it may consistently determine the second peak p2 as the target peak tp by determining the target peak tp in the target voltage region VR.

The control unit 120 may be configured to calculate a ratio of the voltage change amount to the SOH change amount in an SOH section less than or equal to a preset reference SOH.

Specifically, the control unit 120 may diagnose the state of the battery for the SOH section less than or equal to the reference SOH, excluding the initial SOH section.

In general, during the design process of a battery, lithium metal may be deposited on the surface of the negative electrode, and the target voltage of the target peak may decrease due to the negative electrode stabilization reaction in the initial cycle. In such cases, since the state of the battery cannot be considered to be abnormally degraded, the control unit 120 may calculate the ratio of the voltage change amount to the SOH change amount in the SOH section less than or equal to the preset reference SOH.

The reference SOH may be preset as an SOH that may be determined only by associating the change in the target voltage with the degradation state of the battery, either experimentally or theoretically. For example, the reference SOH may be set to any one of the SOH sections less than 100 [%] and greater than or equal to 90 [%]. Preferably, the reference SOH may be set to any one of the SOH sections less than or equal to 98[%] and greater than or equal to 96 [%].

That is, the control unit 120 may calculate the SOH change amount using the reference SOH as the starting SOH, and calculate the voltage change amount using the target voltage corresponding to the reference SOH as the starting voltage. In addition, the control unit 120 may calculate the voltage change rate by calculating the ratio between the calculated SOH change amount and the voltage change amount.

For example, in the embodiment of FIG. 3, the reference SOH may be preset to s0 [%]. Accordingly, the control unit 120 may calculate the voltage change rate in the SOH section less than or equal to the reference SOH (s0) and diagnose the state of the battery according to the calculated voltage change rate.

The apparatus 100 for diagnosing a battery according to an embodiment of the present disclosure may diagnose the state of a battery more conservatively by diagnosing the state of the battery in a limited SOH section. Therefore, according to the apparatus 100 for diagnosing a battery, the accuracy of diagnosing the state of the battery may be improved.

Preferably, the control unit 120 may be configured to set the usage condition of the battery in response to the diagnostic results.

Specifically, the control unit 120 may appropriately change the preset usage condition to correspond to the state of the battery.

For example, the control unit 120 may be configured to change at least one of the maximum allowable temperature, the upper limit SOC, the lower limit SOC, and the upper limit C-rate set for the battery if the state of the battery is a normal degradation state. As described above, the normal degradation state means a state in which the battery is degraded within a normal range. However, even if the state of the battery is a normal degradation state, if this state continues to be maintained, the degradation of the battery may gradually accelerate. Therefore, the control unit 120 may prevent the degradation of the battery from gradually accelerating by changing at least one of the maximum allowable temperature, the upper limit SOC, the lower limit SOC, and the upper limit C-rate of the battery.

As another example, the control unit 120 may be configured to output an alarm if the state of the battery is an abnormal degradation state. As described above, the abnormal degradation means a state in which the battery is degraded outside of a normal range. Therefore, the control unit 120 may immediately output an alarm to notify the outside of the battery state. For example, the control unit 120 may output an alarm to notify the state of the battery to an alarm unit (not shown), a display unit (not shown), a user terminal (not shown), and a server (not shown) connected by wire and/or wirelessly.

The apparatus 100 for diagnosing a battery may increase the expected life of the battery by taking appropriate measures in response to the diagnosis results. In addition, the apparatus 100 for diagnosing a battery may prevent accidents that may occur from the battery in advance by immediately notifying the outside of the battery state when the battery is in an abnormal degradation state.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the profile obtaining unit 110, the control unit 120 and the storage unit 130 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

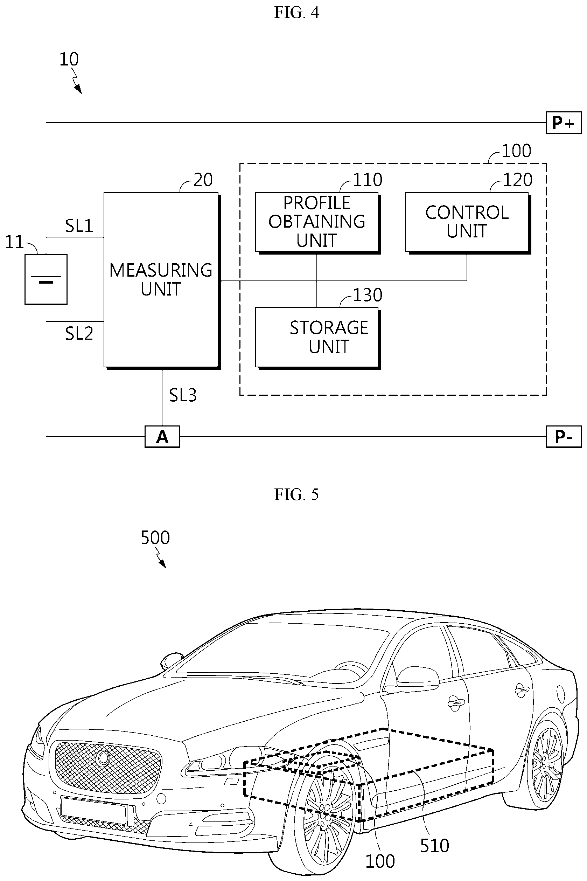

FIG. 4 is a diagram showing a battery pack according to another embodiment of the present disclosure.

The positive electrode terminal of the battery 11 may be connected to the positive electrode terminal P+ of the battery pack 10, and the negative electrode terminal of the battery 11 may be connected to the negative electrode terminal P- of the battery pack 10.

The measuring unit 12 may be connected to the first sensing line SL1, the second sensing line SL2, and the third sensing line SL3. Specifically, the measuring unit 12 may be connected to the positive electrode terminal of the battery 11 through the first sensing line SL1 and connected to the negative electrode terminal of the battery 11 through the second sensing line SL2. The measuring unit 12 may measure the voltage of the battery 11 based on the voltage measured at each of the first sensing line SL1 and the second sensing line SL2.

Also, the measuring unit 12 may be connected to the current measuring unit A through the third sensing line SL3. For example, the current measuring unit A may be an ammeter or a shunt resistor capable of measuring the charging current and the discharging current of the battery 11. The measuring unit 12 may measure the charging current of the battery 11 through the third sensing line SL3 to calculate the charge amount. In addition, the measuring unit 12 may measure the discharging current of the battery 11 through the third sensing line SL3 to calculate the discharge amount.

For example, the profile obtaining unit 110 may receive battery information about the voltage and current of the battery from the measuring unit 12. Then, the profile obtaining unit 110 may generate a battery profile and a differential profile DP based on the battery information.

As another example, the profile obtaining unit 110 may receive a battery profile from the measuring unit 12. Additionally, the profile obtaining unit 110 may generate a differential profile DP based on the battery profile.

As another example, the profile obtaining unit 110 may receive a differential profile DP from the measuring unit 12.

An external device may be connected to the positive electrode terminal P+ and the negative electrode terminal P- of the battery pack 10. For example, the external device may be a charging device or a load. In addition, the positive electrode terminal of the battery 11, the positive electrode terminal P+ of the battery pack 10, the external device, the negative electrode terminal P- of the battery pack 10, and the negative electrode terminal of the battery 11 may be electrically connected.

FIG. 5 is a drawing schematically showing a vehicle 500 according to still another embodiment of the present disclosure.

Referring to FIG. 5, the battery pack 510 according to the embodiment of the present disclosure may be included in a vehicle 500, such as an electric vehicle (EV) or a hybrid vehicle (HV). In addition, the battery pack 510 may drive the vehicle 500 by supplying power to a motor through an inverter provided in the vehicle 500. Here, the battery pack 510 may include the apparatus 100 for diagnosing a battery. That is, the vehicle 500 may include the apparatus 100 for diagnosing a battery. In this case, the apparatus 100 for diagnosing a battery may be an onboard device included in the vehicle 500.

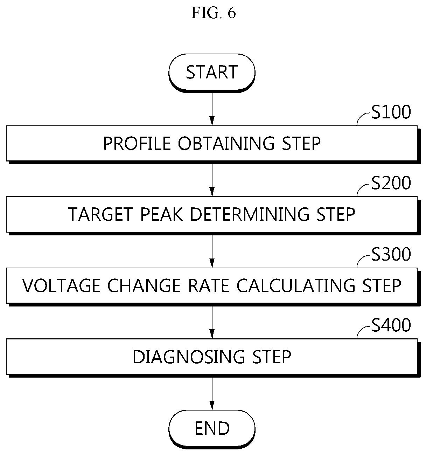

FIG. 6 is a diagram schematically showing a method for diagnosing a battery according to still another embodiment of the present disclosure.

Referring to FIG. 10, the method for diagnosing a battery may include a profile obtaining step (S100), a target peak determining step (S200), a voltage change rate calculating step (S300) and a diagnosing step (S400).

Preferably, each step of the method for diagnosing a battery may be performed by the apparatus 100 for diagnosing a battery. Hereinafter, for convenience of explanation, content that overlaps with the content described above will be omitted or briefly described.

The profile obtaining step (S100) is a step of obtaining a differential profile DP representing a corresponding relationship between a differential capacity and a voltage of a battery, and may be performed by the profile obtaining unit 110.

For example, the profile obtaining unit 110 may directly receive the differential profile DP of the battery from the outside. That is, the profile obtaining unit 110 may obtain the differential profile DP by being connected to the outside by wire and/or wirelessly and receiving the differential profile DP.

As another example, the profile obtaining unit 110 may directly receive the battery profile of the battery from the outside. Then, the profile obtaining unit 110 may differentiate the battery profile with respect to the voltage to generate a differential profile DP. That is, the profile obtaining unit 110 may obtain the differential profile DP by receiving the battery profile through a wired and/or wireless connection to the outside, and directly generating the differential profile DP from the battery profile.

As still another example, the profile obtaining unit 110 may receive battery information about the voltage and capacity of the battery. Then, the profile obtaining unit 110 may generate a battery profile based on the received battery information, and generate a differential profile DP based on the generated battery profile. That is, the profile obtaining unit 110 may obtain a differential profile DP by directly generating the differential profile DP based on the battery information.

The target peak determining step (S200) is a step of determining a target peak in the differential profile DP, and may be performed by the control unit 120.

Preferably, the control unit 120 may be configured to determine a peak having the largest differential capacity among a plurality of peaks included in the differential profile DP as the target peak.

The voltage change rate calculating step (S300) is a step of calculating a voltage change rate based on the SOH of the battery and the target voltage of the target peak, and may be performed by the control unit 120.

For example, the control unit 120 may be configured to calculate a voltage change rate by calculating a ratio of a voltage change amount of a target voltage to a SOH change amount of the battery.

The diagnosing step (S400) is a step for diagnosing the state of the battery by comparing the calculated voltage change rate with a preset reference change rate, and may be performed by the control unit 120.

For example, the control unit 120 may be configured to diagnose the state of the battery as a normal degradation state if the voltage change rate exceeds the reference change rate. As another example, the control unit 120 may be configured to diagnose the state of the battery as an abnormal degradation state if the voltage change rate is less than the reference change rate.

Furthermore, the control unit 120 may appropriately change a preset usage condition to correspond to the state of the battery.

For example, the control unit 120 may be configured to change at least one of a maximum allowable temperature, an upper limit SOC, a lower limit SOC, and an upper limit C-rate set for the battery if the state of the battery is a normal degradation state. As another example, the control unit 120 may be configured to output an alarm if the state of the battery is an abnormal degradation state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

- 10:: battery pack
- 11:: battery
- 12:: measuring unit
- 100:: apparatus for diagnosing a battery
- 110:: profile obtaining unit
- 120:: control unit
- 130:: storage unit
- 500:: vehicle
- 510:: battery pack

## Claims

1. An apparatus for diagnosing a battery, comprising:
a profile obtaining unit configured to obtain a differential profile representing a corresponding relationship between a differential capacity and a voltage of a battery; and
a control unit configured to determine a target peak from the differential profile, calculate a voltage change rate based on a SOH of the battery and a target voltage of the target peak, and compare the calculated voltage change rate with a preset reference change rate to diagnose a state of the battery.

2. The apparatus for diagnosing a battery according to claim 1,
wherein the control unit is configured to determine a peak with a largest differential capacity among a plurality of peaks included in the differential profile as the target peak.

3. The apparatus for diagnosing a battery according to claim 1,
wherein the control unit is configured to calculate the voltage change rate by calculating a ratio of a voltage change amount of the target voltage to a SOH change amount of the battery.

4. The apparatus for diagnosing a battery according to claim 3,
wherein the control unit is configured to calculate the ratio of the voltage change amount to the SOH change amount in a SOH section less than or equal to a preset reference SOH.

5. The apparatus for diagnosing a battery according to claim 1,
wherein the control unit is configured to diagnose the state of the battery as a normal degradation state when the voltage change rate exceeds the reference change rate, and
wherein the control unit is configured to diagnose the state of the battery as an abnormal degradation state when the voltage change rate is less than the reference change rate.

6. The apparatus for diagnosing a battery according to claim 5,
wherein the control unit is configured to change at least one of a maximum allowable temperature, an upper limit SOC, a lower limit SOC and an upper limit C-rate set for the battery when the state of the battery is the normal degradation state.

7. The apparatus for diagnosing a battery according to claim 5,
wherein the control unit is configured to output an alarm when the state of the battery is the abnormal degradation state.

8. A battery pack, comprising the apparatus for diagnosing a battery according to any one of claims 1 to 7.

9. A vehicle, comprising the apparatus for diagnosing a battery according to any one of claims 1 to 7.

10. A method for diagnosing a battery, comprising:
a profile obtaining step of obtaining a differential profile representing a corresponding relationship between a differential capacity and a voltage of a battery;
a target peak determining step of determining a target peak from the differential profile;
a voltage change rate calculating step of calculating a voltage change rate based on a SOH of the battery and a target voltage of the target peak; and
a diagnosing step of comparing the calculated voltage change rate with a preset reference change rate to diagnose a state of the battery.
